# EUROPEAN PATENT APPLICATION

(11) **EP 4 745 711 A1**
(43) Date of publication of application: **20.05.2026**
(21) Application number: 24845851.5
(22) Date of filing: 03.07.2024
(51) Int. Cl.: G06F 1/16

(54) **ELECTRONIC DEVICE COMPRISING SUPPORT BODY**

(30) Priority: 21.07.2023 KR 20230095559; 05.09.2023 KR 20230117561
(71) Applicant: Samsung Electronics Co., Ltd., Suwon-si, Gyeonggi-do 16677 (KR)
(72) Inventor: KIM, Taejeong, Suwon-si Gyeonggi-do 16677 (KR); PARK, Byounggyu, Suwon-si Gyeonggi-do 16677 (KR); SONG, Kyunghwan, Suwon-si Gyeonggi-do 16677 (KR); LEE, Garam, Suwon-si Gyeonggi-do 16677 (KR); CHOI, Hyunsuk, Suwon-si Gyeonggi-do 16677 (KR); NAM, Kiju, Suwon-si Gyeonggi-do 16677 (KR); KIM, Moonsoo, Suwon-si Gyeonggi-do 16677 (KR); JUNG, Junyoung, Suwon-si Gyeonggi-do 16677 (KR); HWANG, Hyunjin, Suwon-si Gyeonggi-do 16677 (KR); SEO, Sungchoul, Suwon-si Gyeonggi-do 16677 (KR)
(74) Representative: Gulde & Partner
(86) International application number: PCT/KR2024/009400
(87) International publication number: WO 2025/023547

(57) **Abstract**

The present disclosure relates to an electronic device. An electronic device according to an embodiment of the present disclosure comprises: a housing comprising a first housing portion and a second housing portion which is formed to move between a retracted position and an extended position with respect to the first housing portion; a flexible display which is arranged on the housing to be movable; and a support body which supports at least part of the flexible display, wherein the support body comprises: a plate comprising a first plate portion facing the flexible display and a second plate portion which faces the flexible display and forms an opening between the first plate portion and the second plate portion; and a support bar which connects the first plate portion and the second plate portion and is formed integrally with the first plate portion and the second plate portion. The support bar may comprise a first portion spaced apart from the opening, and a second portion which extends from the plate with a thickness different from the plate, and is connected to the first portion.

## Description

### [Technical Field]

Various embodiments of the disclosure relate to an electronic device, e.g., an electronic device including a supporting body.

### [Background Art]

With the development of information and communication technology and semiconductor technology, various functions are packed in one portable electronic device. For example, an electronic device may implement not only communication functions but also entertainment functions, such as playing games, multimedia functions, such as playing music and videos, communication and security functions for mobile banking, and scheduling or e-wallet functions. These electronic devices have been downsized to be conveniently carried by users.

As mobile communication services extend up to multimedia service sectors, electronic devices require a larger display to allow users satisfactory use of multimedia services as well as voice call or text messaging services. This, however, trades off the trend of electronic devices being compact.

### [Detailed Description of the Invention]

### [Technical Solution]

An electronic device according to an embodiment of the disclosure may include: a housing including a first housing portion and a second housing portion configured to move between a retracted position and an extended position relative to the first housing portion; a flexible display movably disposed on the housing; and a supporting body configured to support at least a portion of the flexible display, wherein the supporting body includes: a first plate portion facing the flexible display and a second plate portion facing the flexible display and forming an opening between the first plate portion and the second plate portion; connecting the first plate portion and the second plate portion; and a supporting bar formed integrally with the first plate portion and the second plate portion, wherein the supporting bar may include: a first portion spaced apart from the opening; and a second portion extending from the plate with a thickness different from the plate and connected to the first portion.

An electronic device according to an embodiment of the disclosure may include: a housing including a first housing portion and a second housing portion configured to move between a retracted position and an extended position relative to the first housing portion; a flexible display movably disposed on the housing; and a supporting body configured to support at least a portion of the flexible display, wherein the supporting body includes: a plate including a first plate portion facing the flexible display and a second plate portion facing the flexible display and forming an opening between the first plate portion and the second plate portion; and a supporting bar connecting the first plate portion and the second plate portion and having a void formed therein in communication with the opening.

### [Brief Description of Drawings]

FIG. 1 is a block diagram illustrating an electronic device in a network environment according to various embodiments of the disclosure.
FIG. 2 is a view illustrating a state in which a partial area of a display is accommodated in a housing according to an embodiment of the disclosure.
FIG. 3 is a view illustrating a state in which a partial area of a display is extended to the outside of a housing according to an embodiment of the disclosure.
FIG. 4A is an exploded view illustrating an electronic device according to an embodiment of the disclosure.
FIG. 4B is an exploded view illustrating an electronic device according to an embodiment of the disclosure.
FIG. 5A is a cross-sectional view illustrating an electronic device according to an embodiment of the disclosure.
FIG. 5B is a cross-sectional view illustrating an electronic device according to an embodiment of the disclosure.
FIG. 6A is a cross-sectional view illustrating an electronic device according to an embodiment of the disclosure.
FIG. 6B is a cross-sectional view illustrating an electronic device according to an embodiment of the disclosure.
FIG. 7 is a view illustrating a supporting body according to an embodiment of the disclosure.
FIG. 8 is a portion of a cross-sectional view illustrating a supporting body according to an embodiment of the disclosure.
FIG. 9 is a portion of a cross-sectional view illustrating a supporting body according to an embodiment of the disclosure.
FIG. 10A is a portion of a cross-sectional view illustrating a supporting body according to an embodiment of the disclosure.
FIG. 10B is a portion of a cross-sectional view illustrating a supporting body according to an embodiment of the disclosure.
FIG. 10C is a portion of a cross-sectional view illustrating a supporting body according to an embodiment of the disclosure.
FIG. 10D is a portion of a cross-sectional view illustrating a supporting body according to an embodiment of the disclosure.
FIG. 10E is a portion of a cross-sectional view illustrating a supporting body according to an embodiment of the disclosure.
FIG. 10F is a portion of a cross-sectional view illustrating a supporting body according to an embodiment of the disclosure.
FIG. 11A is a portion of a cross-sectional view illustrating a supporting body according to an embodiment of the disclosure.
FIG. 11B is a portion of a cross-sectional view illustrating a supporting body according to an embodiment of the disclosure.
FIG. 11C is a portion of a cross-sectional view illustrating a supporting body according to an embodiment of the disclosure.
FIG. 12A is an enlarged view illustrating a partial area of a supporting body according to an embodiment of the disclosure.
FIG. 12B is an enlarged view illustrating a partial area of a supporting body according to an embodiment of the disclosure.
FIG. 13A is a view illustrating a manufacturing process of a supporting body according to an embodiment of the disclosure.
FIG. 13B is a view illustrating a manufacturing process of a supporting body according to an embodiment of the disclosure.
FIG. 13C is a view illustrating a manufacturing process of a supporting body according to an embodiment of the disclosure.
FIG. 13D is a view illustrating a manufacturing process of a supporting body according to an embodiment of the disclosure.

### [Mode for Carrying out the Invention]

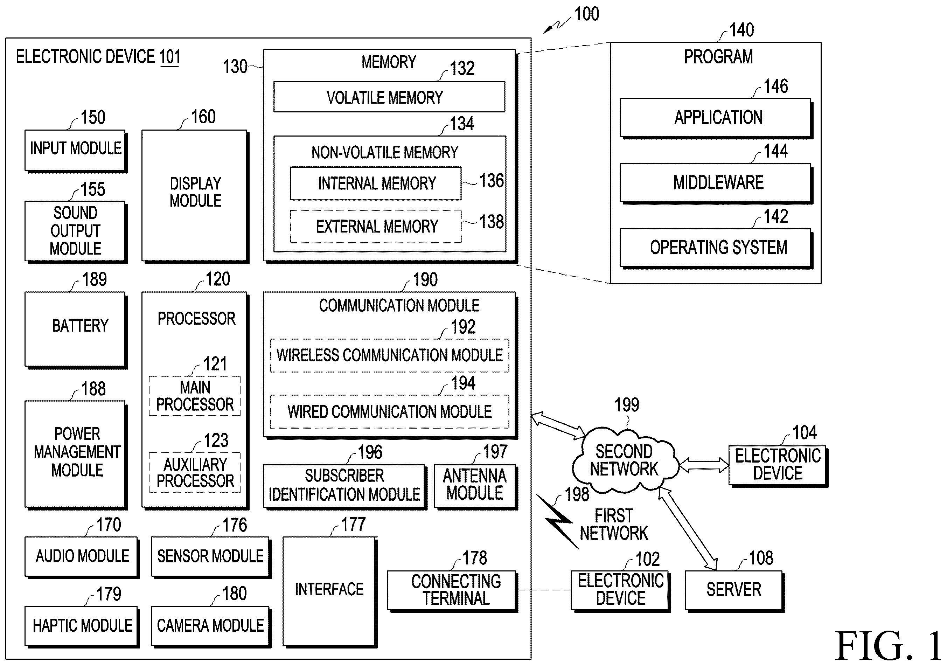

FIG. 1 is a block diagram illustrating an electronic device 101 in a network environment 100, according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

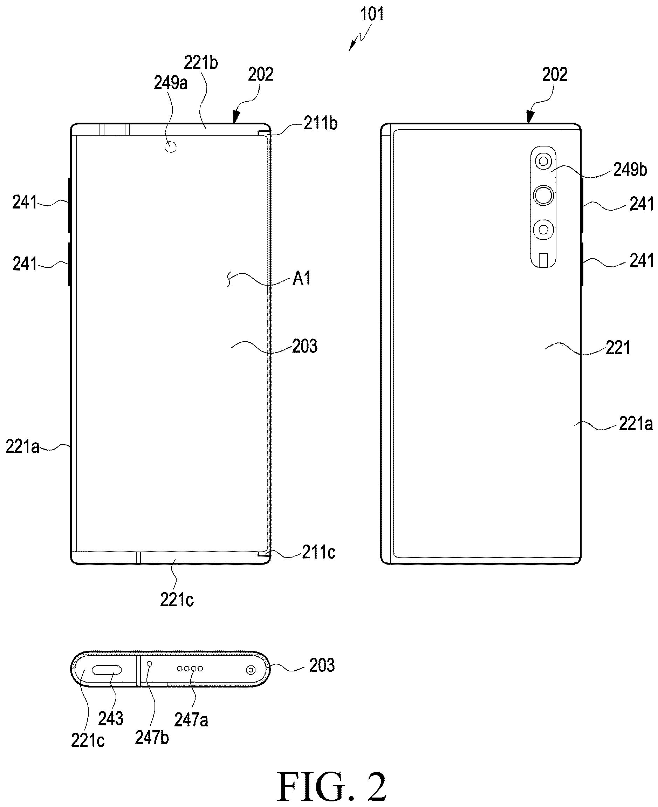

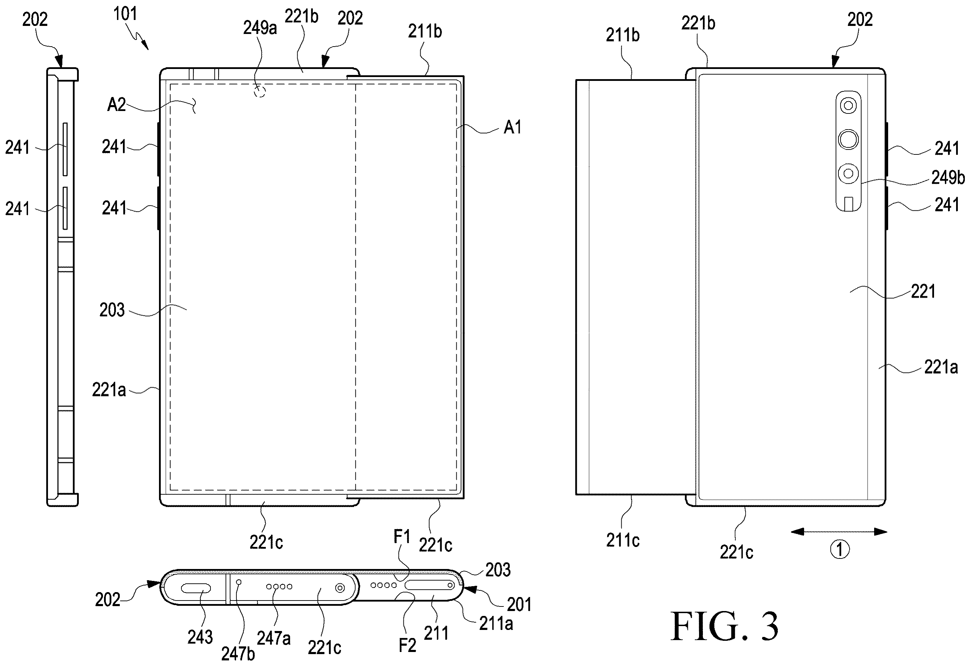

FIG. 2 is a view illustrating a state in which a second display area of a display is received in a second housing, according to one of various embodiments of the disclosure; FIG. 3 is a view illustrating a state in which a second display area of a display is exposed to the outside of a second housing, according to one of various embodiments of the disclosure;

FIGS. 2 and 3 illustrate a structure in which the display 203 (e.g., flexible display) is extended to the right when the electronic device 101 is viewed from the front. However, the extending direction of the display 203 is not limited to one direction (e.g., right direction), but design changes may be made so that the display 203 is extendable in the left direction, upper/lower directions, and/or two directions.

The state shown in FIG. 2 may be defined as a first housing 201 being closed with respect to a second housing 202, and the state shown in FIG. 3 may be defined as the first housing 201 being open with respect to the second housing 202. According to an embodiment, the "closed state" or "opened state" may be defined as a closed or opened state of the electronic device 101. The first housing 201 may be referred to as a "first housing portion." The second housing 202 may be referred to as a "second housing portion."

Referring to FIGS. 2 and 3, the electronic device 101 may include housings 201 and 202. The housings 201 and 202 may include a second housing 202 and a first housing 201 movably disposed with respect to the second housing 202. According to an embodiment, the electronic device 101 may be interpreted as having a structure in which the second housing 202 is slidably disposed on the first housing 201. According to an embodiment, the first housing 201 may be disposed to perform reciprocating motion by a predetermined distance in a predetermined direction with respect to the second housing 202, for example, a direction indicated by an arrow ①.

According to an embodiment, the first housing 201 may be referred to as, for example, a first structure, a slide unit, or a slide housing, and may be disposed to reciprocate on the second housing 202. According to an embodiment, the first housing 201 may receive various electrical/electronic components, such as a circuit board or a battery. The second housing 202 may be referred to as, e.g., a second structure, a main part, or a main housing, and may guide the movement of the first housing 201. A portion (e.g., the first display area A1) of the display 203 may be seated on the first housing 201. According to an embodiment, another portion (e.g., the second display area A2) of the display 203 may be received into the inside of the second housing 202 (e.g., a slide-in motion) or be exposed to the outside of the second housing 202 (e.g., a slide-out motion) as the first housing 201 moves (e.g., slides) with respect to the second housing 202. According to an embodiment, a motor, a speaker, a sim socket, and/or a sub circuit board electrically connected with a main circuit board may be disposed in the first housing 201. A main circuit board on which electrical components, such as an application processor (AP) and a communication processor (CP) are mounted may be disposed in the second housing 202.

According to various embodiments, the first housing 201 may include a first plate 211 (e.g., a slide plate). The first plate 211 may include a first surface (e.g., the first surface F1 of FIG. 3) forming at least a portion of the first plate 211 and a second surface F2 facing away from the first surface F1. According to an embodiment, the first plate 211 may support at least a portion of the display 203 (e.g., the first display area A1). According to an embodiment, the first housing 201 may include a first plate 211, a 1-1th side wall 211a extending from the first plate 211, a 1-2th side wall 211b extending from the 1-1th side wall 211a and the first plate 211, and a 1-3th side wall 211c extending from the 1-1th side wall 211a and the first plate 211 and positioned substantially parallel to the 1-2th side wall 211b.

According to various embodiments, the second housing 202 may include a second plate 221 (e.g., main case), a 2-1th side wall 221a extending from the second plate 221, a 2-2th side wall 221b extending from the 2-1th side wall 221a and the second plate 221, and a 2-3th side wall 221c extending from the 2-1th side wall 221a and the second plate 221 and disposed substantially parallel to the 2-2th side wall 221b. According to an embodiment, the 2-2th sidewall 221b and the 2-3th sidewall 221c may be formed substantially perpendicular to the 2-1th sidewall 221a. According to an embodiment, the second plate 221, the 2-1th sidewall 221a, the 2-2th sidewall 221b, and the 2-3th sidewall 221c may be formed to have an opening in one surface (e.g., the front surface) to receive at least a portion of the first housing 201. For example, the first housing 201 may be coupled to the second housing 202 in a state in which it is at least partially surrounded, and the first housing 201 may be slide in a direction parallel to the first surface F1 or the second surface F2, for example, direction ① indicated with the arrow. According to an embodiment, the second plate 221, the 2-1th sidewall 221a, the 2-2th sidewall 221b, and/or the 2-3th sidewall 221c may be integrally formed. According to another embodiment, the second plate 221, the 2-1th sidewall 221a, the 2-2th sidewall 221b, and/or the 2-3th sidewall 221c may be formed as separate housings and be combined or assembled.

According to various embodiments, the second plate 221 and/or the 2-1th sidewall 221a may cover at least a portion of the display 203. For example, at least a portion of the display 203 may be received in the second housing 202. The second plate 221 and/or the 2-1th sidewall 221a may cover a portion of the flexible display 203 received in the second housing 202.

According to various embodiments, the first housing 201 may be moved into an opened state and closed state with respect to the second housing 202 in a first direction (e.g., direction ①) parallel to the 2-2th sidewall 221b or the 2-3th sidewall 221c. The first housing 201 may be moved to be positioned at a first distance from the 2-1th sidewall 221a in the closed state. In the opened state, the first housing 201 may be moved to be positioned at a second distance greater than the first distance from the 2-1th sidewall 221a. In some embodiments, in the closed state, the first housing 201 may surround a portion of the 2-1th side wall 221a.

According to various embodiments, the electronic device 101 may include a display 203, a key input device 241, a connector hole 243, audio modules 247a and 247b, or camera modules 249a and 249b. Although not shown, the electronic device 101 may further include an indicator (e.g., a light emitting diode (LED) device) or various sensor modules.

According to various embodiments, the display 203 may include a first display area A1 and a second display area A2. According to an embodiment, the first display area A1 may be disposed on the second housing 202. The second display area A2 may extend from the first display area A1 and, as the first housing 201 slides, the second display area A2 may be inserted or received in the second housing 202 (e.g., structure) or exposed to the outside of the second housing 202.

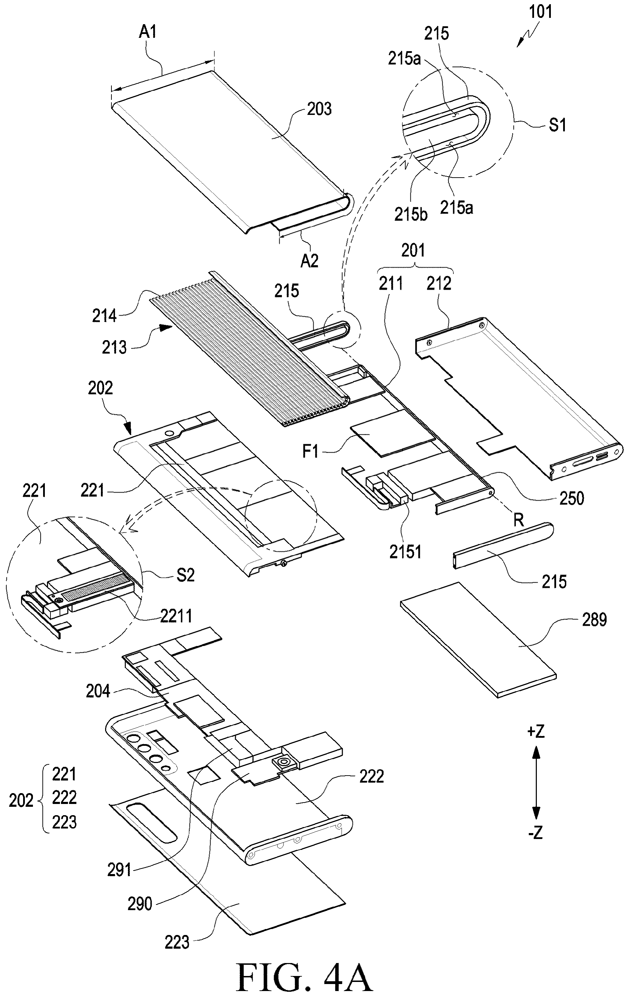

According to various embodiments, the second display area A2 may be substantially moved while being guided by an area (e.g., the curved surface 250 of FIG. 4A) of the first housing 201 and may be thus received in, or exposed to the outside of, the second housing 202 or a space formed between the first housing 201 and the second housing 202. According to an embodiment, the second display area A2 may move based on a slide of the first housing 201 in the first direction (e.g., the direction indicated by the arrow ①) of the first housing 201. For example, while the first housing 201 slides, a portion of the second display area A2 may be deformed into a curved shape in a position corresponding to the curved surface 250 of the first housing 201.

According to various embodiments, when viewed from above the first plate 211 (e.g., slide plate), if the first housing 201 moves from the closed state to the opened state, the second display area A2 may be exposed to the outside of the second housing 202 to be substantially coplanar with the first display area A1. The display 203 may be disposed to be coupled with, or adjacent, a touch detecting circuit, a pressure sensor capable of measuring the strength (pressure) of touches, and/or a digitizer for detecting a magnetic field-type stylus pen. In one embodiment, the second display area A2 may be at least partially received inside the second housing 202, and a portion of the second display area A2 may be visually exposed to the outside even in the state shown in FIG. 2 (e.g., the closed state). According to an embodiment, irrespective of the closed state or the opened state, the exposed portion of the second display area A2 may be positioned on a portion (e.g., the curved surface 250 of FIG. 4A) of the first housing, and a portion of the second display area A2 may remain in the curved shape in the position corresponding to the curved surface 250.

According to various embodiments, the key input device 241 may be positioned in one area of the first housing 201. Depending on the appearance and the state of use, the electronic device 101 may be designed to omit the illustrated key input device 241 or to include additional key input device(s). According to an embodiment, the electronic device 101 may include a key input device (not shown), e.g., a home key button or a touchpad disposed around the home key button. According to another embodiment, at least a portion of the key input device 241 may be disposed on the 2-1th side wall 221a, the 2-2th side wall 221b, or the 2-3th side wall 221c of the second housing 202.

According to various embodiments, the connector hole 243 may be omitted or may receive a connector (e.g., a universal serial bus (USB) connector) for transmitting and receiving power and/or data with an external electronic device. Although not shown, the electronic device 101 may include a plurality of connector holes 243, and some of the plurality of connector holes 243 may function as connector holes for transmitting/receiving audio signals with an external electronic device. In the illustrated embodiment, the connector hole 243 is disposed in the 2-3th sidewall 221c but is not limited thereto. The connector hole 243 or a connector hole not shown may be disposed in the 2-1th sidewall 221a or the 2-2th sidewall 221b.

According to various embodiments, the audio modules 247a and 247b may include at least one speaker hole 247a or at least one microphone hole 247b. One of the speaker holes 247a may be provided as a receiver hole for voice calls, and the other may be provided as an external speaker hole. The electronic device 101 may include a microphone for obtaining sound. The microphone may obtain external sound of the electronic device 101 through the microphone hole 247b. According to an embodiment, the electronic device 101 may include a plurality of microphones to detect the direction of sound. According to an embodiment, the electronic device 101 may include an audio module in which the speaker hole 247a and the microphone hole 247b are implemented as one hole or may include a speaker without the speaker hole 247a (e.g., a piezo speaker).

According to various embodiments, the camera modules 249a and 249b may include a first camera module 249a and a second camera module 249b. The electronic device 101 may include a plurality of camera modules 249a and 249b. For example, the electronic device 101 may include at least one of a wide-angle camera, a telephoto camera, or a close-up camera. According to an embodiment, the electronic device 101 may measure the distance to the subject by including an infrared projector and/or an infrared receiver. The camera modules 249a and 249b may include one or more lenses, an image sensor, and/or an image signal processor. The first camera module 249a may be disposed to face in the same direction as the display 203. For example, the first camera module 249a may be disposed in an area around the first display area A1 or overlapping the display 203. When disposed in the area overlapping the display 203, the first camera module 249a may capture the subject through the display 203. According to an embodiment, the first camera module 249a may include an under display camera (UDC) that has a screen display area (e.g., the first display area A1) that may not be visually exposed but hidden. The second camera module 249b may be positioned in the first housing 201 and may capture a subject in a direction opposite to the first display area A1 of the display 203.

According to various embodiments, an indicator (not shown) of the electronic device 101 may be disposed on the first housing 201 or the second housing 202, and the indicator may include a light emitting diode to provide state information about the electronic device 101 as a visual signal. The sensor module (not shown) of the electronic device 101 may produce an electrical signal or data value corresponding to the internal operation state or external environment state of the electronic device. The sensor module may include, for example, a proximity sensor, a fingerprint sensor, or a biometric sensor (e.g., an iris/face recognition sensor or a heartrate monitor (HRM) sensor). According to another embodiment, the sensor module may further include, e.g., at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor.

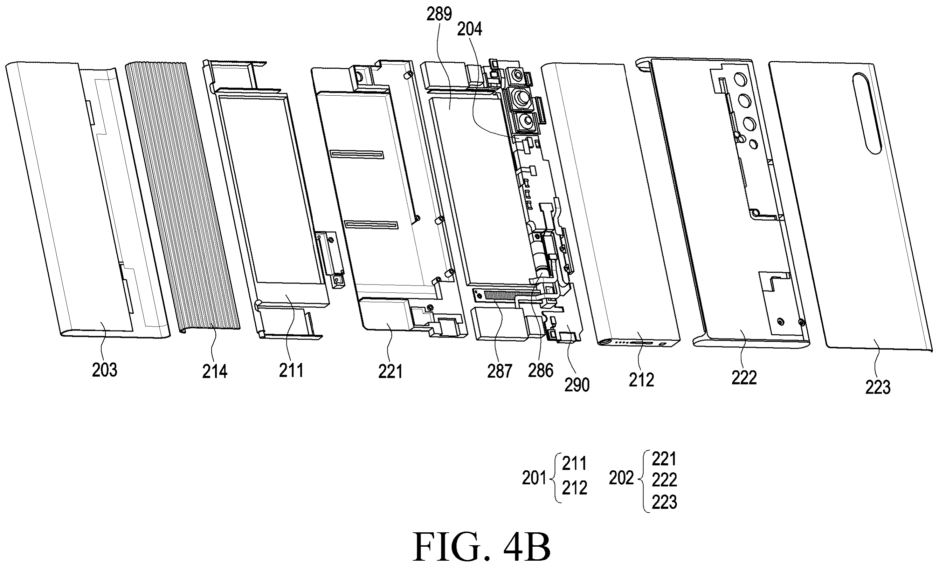

FIGS. 4A and 4B are exploded perspective views illustrating an electronic device according to various embodiments of the disclosure.

Referring to FIGS. 4A and 4B, the electronic device 101 may include a first housing 201, a second housing 202, a display 203 (e.g., a flexible display, a foldable display, or a rollable display), and/or a support structure 213 (e.g., an articulated hinge structure or multi-bar structure). A portion (e.g., the second display area A2) of the display 203 may be received in the electronic device 101 along the curved surface 250 of the first housing 201.

The configuration of the first housing 201, the second housing 202, and the display 203 of FIGS. 4A and 4B may be identical in whole or part to the configuration of the first housing 201, the second housing 202, and the display 203 of FIGS. 2 and 3.

According to various embodiments, the first housing 201 may include a first plate 211 and a slide cover 212. The first plate 211 and the slide cover 212 may be mounted (e.g., at least partially connected) on the second housing 202 and be reciprocated in one direction (e.g., direction ① indicated by the arrow in FIGS. 2 and 3) while being guided by the second housing 202. According to an embodiment, the first plate 211 may support the display 203. For example, the first plate 211 may include a first surface F1. The second display area A2 of the display 203 may be substantially positioned on the first surface F1 to maintain a flat panel shape. The slide cover 212 may protect the display 203 positioned on the first plate 211. For example, at least a portion of the display 203 may be positioned between the first plate 211 and the slide cover 212. According to an embodiment, the first plate 211 and the slide cover 212 may be formed of a metal material and/or a non-metal (e.g., polymer) material. According to an embodiment, the first plate 211 may receive at least some (e.g., the battery 289, motor structure 286, and rack 287) of the components of the electronic device 101.

According to various embodiments, the support structure 213 may support the display 203. For example, the support structure 213 may be connected to or attached to at least a portion (e.g., the second display area A2) of the display 203. According to an embodiment, the support structure 213 may be positioned between the first plate 211 and the slide cover 212. According to an embodiment, as the first housing 201 slides in one direction (e.g., direction η of FIGS. 2 and 3), the support structure 213 may move with respect to the second housing 202. As the first housing 201 moves in the one direction, the support structure 213 may move with respect to the second housing 202. As the first housing 201 slides in the one direction, the support structure 213 may move with respect to the second housing 202. In the closed state (e.g., FIG. 2) of the support structure 213, most of the structure may be received in the second housing 202. According to an embodiment, at least a portion of the support structure 213 may move corresponding to the curved surface 250 positioned at the edge of the first housing 201. The support structure 213 may be named as a "supporting body."

According to various embodiments, the support structure 213 may include a plurality of bars (or a plurality of bars 214 (rods)). The plurality of bars 214 may extend in a straight line and be disposed parallel to the rotational axis R formed by the curved surface 250, and the plurality of bars 214 may be arranged along a direction substantially perpendicular to the rotational axis R (e.g., the direction along which the first housing 201 slides).

According to various embodiments, the electronic device 101 may include a guide rail 215 capable of guiding movement of the plurality of bars 214. The guide rail 215 may include an upper guide rail coupled with an upper end of the first plate 211 and connected with upper ends of the plurality of bars 214 and a lower guide rail coupled with a lower end of the first plate 211 and connected with lower ends of the plurality of bars 214. According to an embodiment, referring to a first enlarged area S1, when the plurality of bars 214 are bent or slid while moving along the curved surface 250, the upper ends and/or lower ends of the plurality of bars 214 may be moved while remaining fitted into the guide rail 215. For example, an upper portion and/or a lower portion of the plurality of bars 214 may slide along a groove-shaped rail 215a while being fitted in the rail 215a formed inside the guide rail 215.

According to an embodiment, by driving of the motor structure 286 (e.g., driving for display slide-out), the first plate 211 on which the motor structure 286 is disposed performs a slide-out operation, and the protruding portion 215b inside the guide rail 215 may push out the upper portion and/or the lower portion of the bent plurality of bars 214. Accordingly, the display 203 received between the first plate 211 and the slide cover 212 may be extended to the front. According to an embodiment, by driving of the motor structure 286 (e.g., driving for display slide-in), the first plate 211 on which the motor structure 286 is disposed performs a slide-in operation, and an outer portion of the guide rail 215 (e.g., a portion except for the protruding portion 215b) may push out the upper portion and/or the lower portion of the bent plurality of bars 214. Accordingly, the extended display 203 may be received between the first plate 211 and the slide cover 212.

According to an embodiment, the rack 287 may be disposed in the second housing 202 and guide the slide of the first housing 201 and the display 203. The second enlarged area S2 represents the rear surface (e.g., the surface facing the -Z axis) of the second plate 221. Referring to the second enlarged area S2, the rack 287 is fixedly disposed on one surface (e.g., one surface facing the -Z axis) of the second plate 221 of the second housing 202 and may guide a gear connected to the motor structure (or motor) 286 to move while rotating in a slide movement direction. According to another embodiment, the rack 287 may be disposed in the first housing 201, and the motor structure 286 may be disposed in the second housing 202. The rack 287 may guide the sliding motion of the second housing 202 and the display 203. For example, the rack 287 is fixedly disposed on the first plate 211 of the first housing 201 and may slide while rotating with a gear connected to the motor structure 286 disposed on the second plate 221 of the second housing 202.

According to various embodiments, the second housing 202 may include a second plate 221, a second plate cover 222, and a third plate 223. The second plate 221 may support the electronic device 101 overall. The first plate 211 may be disposed on one surface of the second plate 221, and a printed circuit board 204 may be coupled to the other surface of the second plate 221. According to an embodiment, the second plate 221 may receive components (e.g., a battery 289, the printed circuit board 204) of the electronic device 101. The second plate cover 222 may protect various components positioned on the second plate 221.

According to various embodiments, a plurality of circuit boards may be received in the second housing 202. A processor, memory, and/or interface may be mounted on the printed circuit board 204 which is the main board. The processor may include one or more of, e.g., a central processing unit, an application processor, a graphic processing device, an image signal processing, a sensor hub processor, or a communication processor. According to various embodiments, the printed circuit board 204 may include a flexible printed circuit board type radio frequency cable (FRC). For example, the printed circuit board 204 may be disposed on at least a portion of the second plate 221 and may be electrically connected to the antenna module and the communication module.

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to various embodiments, the electronic device 101 may further include a separate sub circuit board 290 spaced apart from the printed circuit board 240 in the second housing 202. The sub circuit board 290 may be electrically connected with the printed circuit board 240 through the flexible circuit board 291. The sub circuit board 290 may be electrically connected with electric components disposed in an end area of the electronic device 101, such as the battery 289 or a speaker and/or a sim socket, and may transfer signals and power.

According to various embodiments, the battery 289 may be a device for supplying power to at least one component of the electronic device 101. The battery 289 may include, e.g., a primary cell which is not rechargeable, a secondary cell which is rechargeable, or a fuel cell. At least a portion of the battery 289 may be disposed on substantially the same plane as the printed circuit board 204. The battery 289 may be integrally or detachably disposed inside the electronic device 101.

According to an embodiment, the battery 289 may be formed of a single embedded battery or may include a plurality of removable batteries. For example, when the embedded battery is positioned on the first plate 211, the embedded battery may move as the first plate 211 slides.

According to various embodiments, the third plate 223 may substantially form at least a portion of the exterior of the second housing 202 or the electronic device 101. For example, the third plate 223 may be coupled to the outer surface of the second plate cover 222. According to an embodiment, the third plate 223 may be integrally formed with the second plate cover 222. According to an embodiment, the third plate 223 may provide a decorative effect on the exterior of the electronic device 101. The second plate 221 and the second plate cover 222 may be formed of at least one of a metal or a polymer, and the third plate 223 may be formed of at least one of metal, glass, synthetic resin or ceramic. According to an embodiment, the second plate 221, the second plate cover 222 and/or the third plate 223 may be formed of a material that transmits light at least partially (e.g., the auxiliary display area). For example, in a state in which a portion of the display 203 (e.g., the second display area A2) is received in the electronic device 101, the electronic device 101 may output visual information using the second display area A2. The auxiliary display area may be a portion of the second plate 221, the second plate cover 222, and/or the third plate 223 in which the display 203 received in the second housing 202 is positioned.

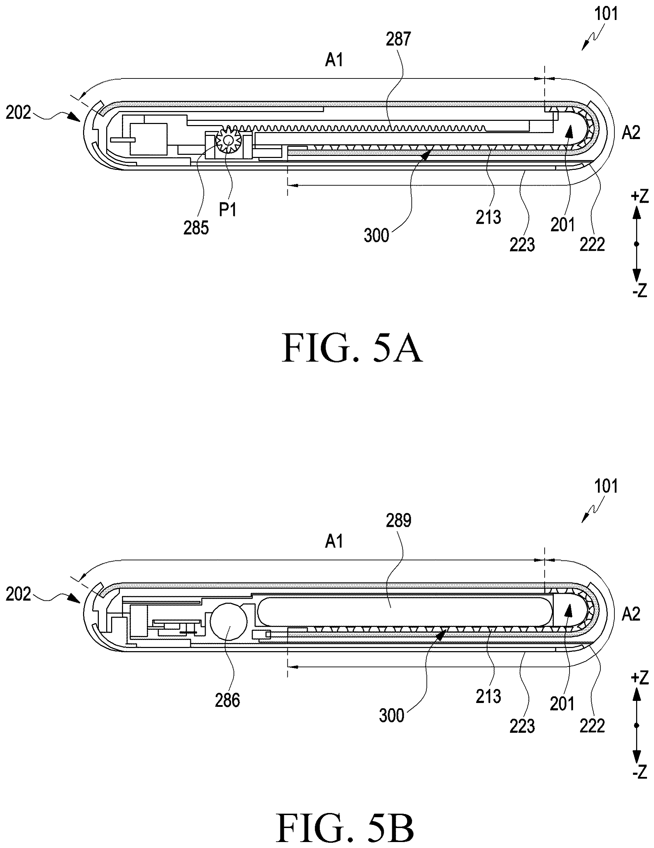

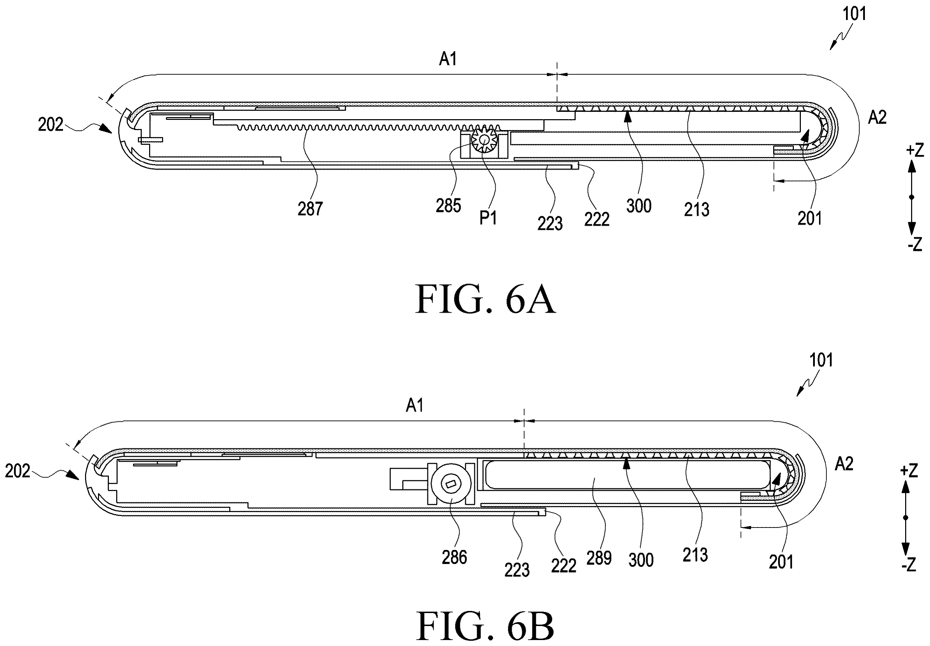

FIG. 5A is a cross-sectional view illustrating an associated configuration of a gear connected with a motor and a rack in a closed state of an electronic device according to various embodiments of the disclosure. FIG. 5B is a cross-sectional view illustrating an arrangement relationship between a motor and a battery in a closed state of an electronic device according to various embodiments of the disclosure. FIG. 6A is a cross-sectional view illustrating an associated configuration of a gear connected with a motor and a rack in an open state of an electronic device according to various embodiments of the disclosure. FIG. 6B is a cross-sectional view illustrating an arrangement relationship between a motor and a battery in an open state of an electronic device according to various embodiments of the disclosure.

According to various embodiments, the electronic device 101 may include a first housing 201, a second housing 202, a display 203, and a driving structure (e.g., the rack 287 and the motor structure 286). The electronic device 101 may further include various components (e.g., a camera module and a battery) disposed in the first housing 201 or the second housing 202.

The configuration of the first housing 201 and the second housing 202 of FIGS. 5A to 6B may be identical in whole or part to the configuration of the first housing 201 and the second housing 202 of FIGS. 2 to 4B.

According to various embodiments, as the first housing 201 (and the flexible display 203 connected to the first housing 201) slides in-out with respect to the second housing 202, the second housing 202 may be in a closed state or an open state.

According to various embodiments, the electronic device 101 may include a driving structure for automatically or semi-automatically providing a slide-in/out operation of the display 203. For example, when the user presses an open trigger button (e.g., the key input device 241 of FIG. 2) exposed outside the electronic device 101, the display 203 may automatically slide in or out (automatic operation). As another example, when the user slides out the display 203 by pushing the display 203 of the electronic device 101 up to a designated section, for the remaining section, it may be completely slid out by the force of the elastic member mounted in the electronic device 101 (semi-automatic operation). The slide-in operation of the electronic device 101 may also be performed to correspond to the slide-out operation (semi-automatic operation).

According to an embodiment, the driving structure may include a motor structure 286, a gear 285 mounted on an end portion of the motor structure 286, a rack 287, and a sub circuit board (not shown) electrically connected to the motor structure 286. According to an embodiment, the gear 285 may be a pinion gear. According to an embodiment, the rack 287 may be engaged with the gear 285. For example, the gear 285 may rotate based on the rotation of the motor structure 286, and the rack 287 may receive at least a portion of the driving force generated by the motor structure 286 through the gear 285.

According to an embodiment, the motor structure 286 may be disposed in the first housing 201 to be slidable with respect to the second housing 202. The motor structure 286 may transfer a driving force to the gear 285 connected to the end portion.

According to an embodiment, the motor structure 286 may be disposed not to overlap the second display area A2 of the display 203. For example, the axis P1 of the motor structure 286 may be disposed perpendicular to the sliding direction, and one surface of the motor structure 286 facing in the +Z-axis direction may overlap the first display area A1, but one surface of the motor structure 286 facing in the -Z-axis direction may not overlap the second display area A2 regardless of the slide-in/out of the display 203. One surface of the motor structure 286 facing in the -Z-axis direction may face the first housing 201 in the slide-in state of the display 203, and may face the second housing 202 in the slide-out state of the display 203. According to an embodiment, the motor structure 286 may be disposed in parallel with at least a portion of the battery 289, and may be electrically connected to the sub circuit board disposed adjacent thereto.

According to an embodiment, the rack 287 may be disposed in the second housing 202 and guide the slide of the first housing 201 and the display 203. The rack 287 may be fixedly disposed on one surface (e.g., one surface facing the -Z-axis) of the second plate 221 of the second housing 202, and may guide the gear 285 to move while rotating in the sliding direction. At least a portion of one surface of the rack 287 facing in the -Z-axis direction may face the second display area A2 in the slide-in state of the display 203, and may not face the second display area A2 in the slide-out state of the display 203. According to an embodiment, the rack 287 may be disposed not to overlap the battery 289. For example, a detachable battery may be disposed in the electronic device 101, and the rack 287 may be positioned between the batteries when viewed toward the rear surface.

According to an embodiment, the gear 285 may be positioned on the axis P1 of the motor structure 286, and may slide the first housing 201 and the display 203 while rotating along the rack 287. When the first housing 201 slides due to the rotation of the gear 285, an electrical component (hereinafter, referred to as a first electrical component) disposed in the first housing 201 may also slide. For example, the first electrical component may be at least one of the motor structure 286, components disposed on the sub circuit board 290, a speaker, or a SIM socket. As another example, the first electrical component may be the battery 289. When the battery 289 is a detachable battery, it may be at least one of the detachable batteries.

According to an embodiment, the sub circuit board may be disposed adjacent to the motor structure 286 and/or the rack 287 within the first housing 201. The sub circuit board 290 may be a configuration for being electrically connected to a main circuit board (e.g., the printed circuit board 204 of FIG. 4A) disposed in the second housing 202. The main circuit board may receive an electrical structure (e.g., the processor) to control driving of the motor structure 286 or provide power to the motor structure 286. The sub circuit board may be electrically connected to the main circuit board 204 to transmit signals for controlling driving or power of the motor structure 286. According to an embodiment, the sub circuit board and the main circuit board 204 may be rigid boards, and the electronic device 101 may further include a separate connection flexible printed circuit board (FPCB) for connecting the sub circuit board and the main circuit board 204. According to another embodiment, power from the battery 289 disposed adjacent to the motor structure 286 may be directly provided through the sub circuit board.

According to an embodiment, the electronic device 101 may include a support 300. The supporting body 300 may be named as a "support structure." The supporting body 300 may support the display 203. The supporting body 300 may extend in a direction in which the display 203 extends. The supporting body 300 may be the same as the support structure 213 described with reference to FIGS. 1 to 6B.

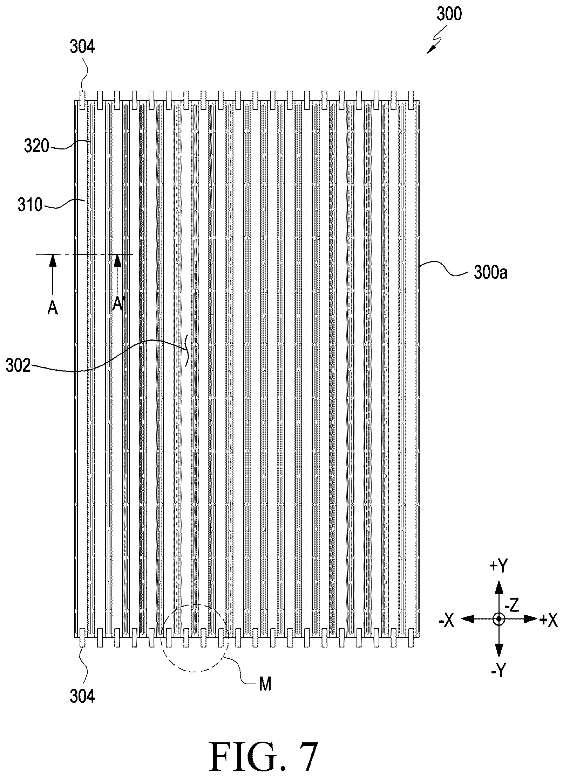

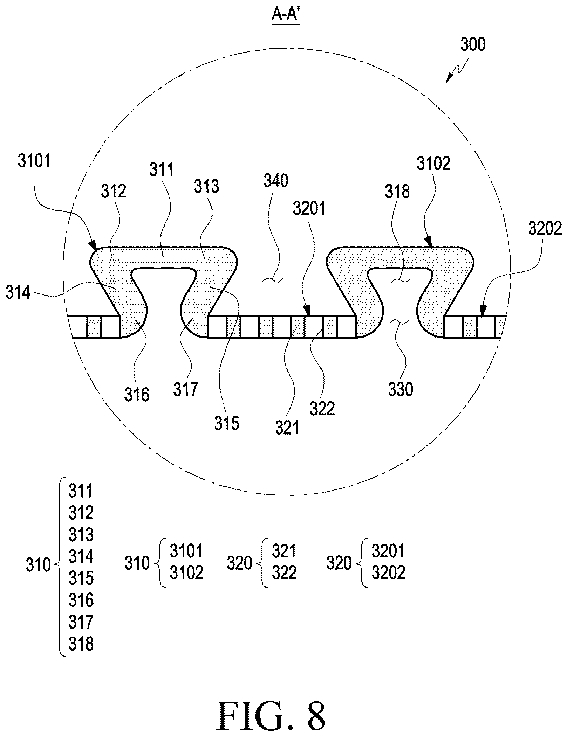

FIG. 7 is a view illustrating a supporting body 300 according to an embodiment of the disclosure. Some or all of the components described with reference to FIG. 7 may be the same as all or some of the components described with reference to FIGS. 1 to 6B. Components described with reference to FIG. 7 may be identical in whole or part to the components described with reference to FIGS. 8 to 13D.

According to an embodiment, a supporting body 300 may include a plurality of supporting bars 310 and a plurality of plates 320. Each of the plurality of supporting bars 310 may be disposed between the plurality of plates 320. Each of the plurality of plates 320 may be disposed between the plurality of supporting bars 310. The plurality of supporting bars 310 and the plurality of plates 320 may be integral. The supporting body 300 may be named as a "lattice plate." Each of the plurality of plates 320 may be spaced apart from each other to form a space 302 therebetween, and each of the plurality of supporting bars 310 may be positioned within the space 302. An end portion 300a of the supporting body 300 may be a portion of the plate 320.

According to an embodiment, the supporting body 300 may include a head 304. The plurality of heads 304 may be disposed corresponding to each of the plurality of supporting bars 310. The head 304 may be integral with the supporting bar 310. The head 304 may protrude from each of one end and the other end of the supporting bar 310. The head 304 may be inserted into a guide rail (e.g., the guide rail 215 of FIG. 4A) and may be moved along the guide rail 215.

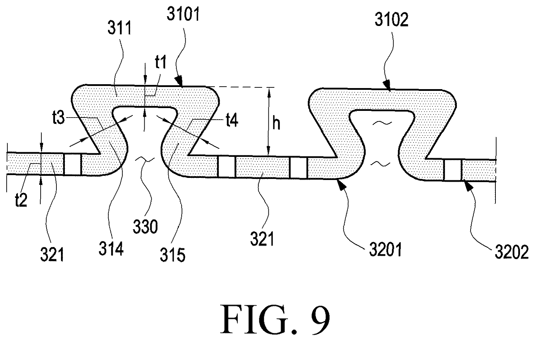

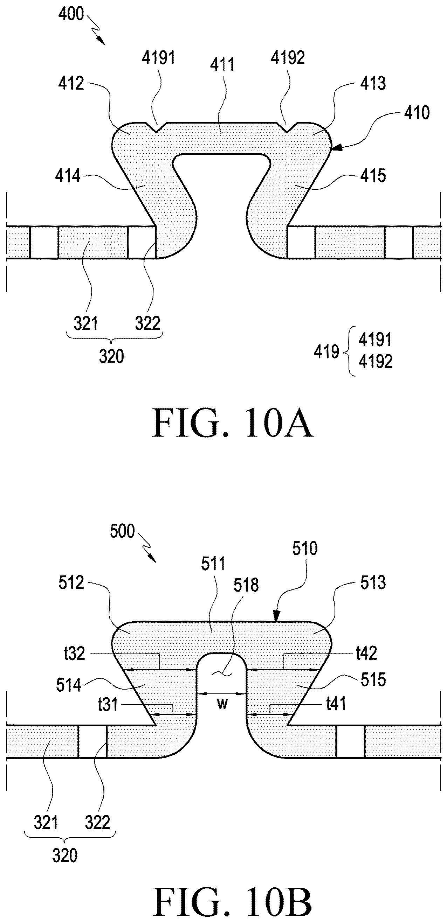

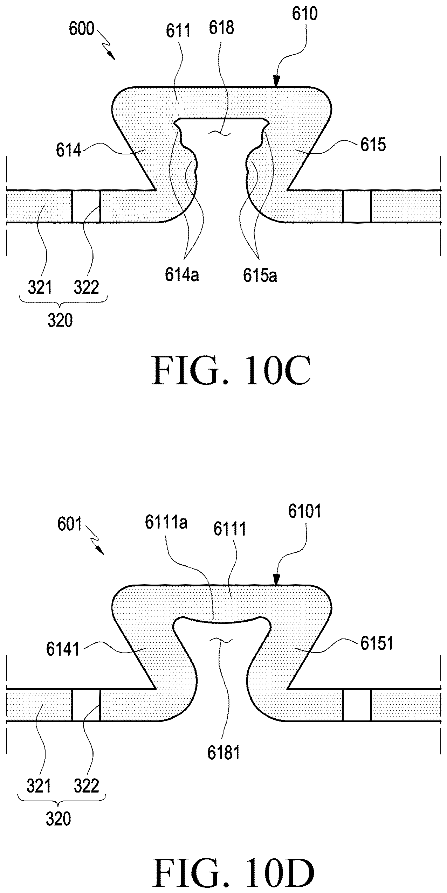

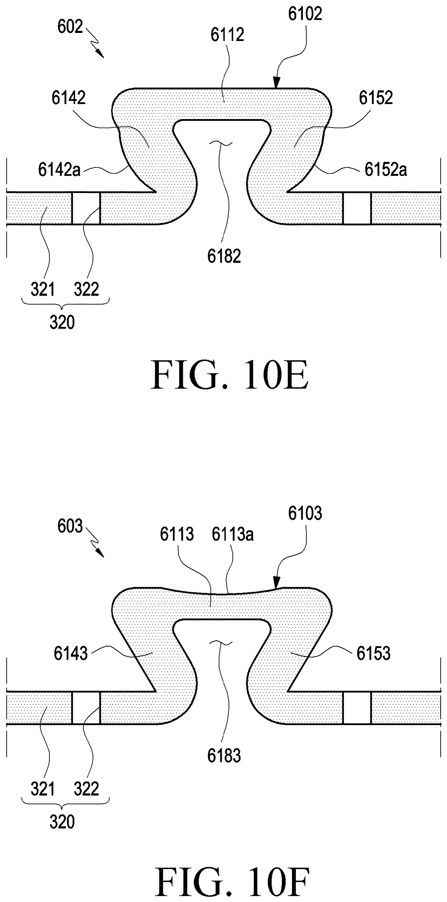

FIG. 8 is a cross-sectional view taken along the line A-A' illustrated in FIG. 7. FIG. 9 is a cross-sectional view taken along the line A-A' illustrated in FIG. 7. Some or all of the components described with reference to FIGS. 8 and 9 may be the same as those described with reference to FIGS. 1 to 7. Components described with reference to FIGS. 8 and 9 may be identical in whole or part to the components described with reference to FIGS. 10 to 13D.

According to an embodiment, the definition of "connect" used in the disclosure is "join (two or more things) together," and "two or more things" in the definition may be two or more portions of one component that are integral. The meaning of "connect" used in the disclosure may be "join a first portion and a second portion of an integral component."

According to an embodiment, the supporting body 300 may include a supporting bar 310 and a plate 320. The plurality of supporting bars 310 may be disposed to be spaced apart from each other. The plurality of plates 320 may be disposed to be spaced apart from each other. The supporting bar 310 may be disposed between a pair of plates 320 spaced apart from each other. The plate 320 may be disposed between a pair of supporting bars 310 spaced apart from each other. The supporting bar 310 and the plate 320 may be integral. The supporting bar 310 may form a portion of the supporting body 300, and the plate 320 may form the remaining portion of the supporting body 300.

According to an embodiment, a supporting bar 310 may include a first supporting bar 3101. The supporting bar 310 may include a second supporting bar 3102. The first supporting bar 3101 and the second supporting bar 3102 may be spaced apart from each other. The plate 320 may include a first plate 3201. The plate 320 may include a second plate 3202. The first plate 3201 and the second plate 3202 may be spaced apart from each other. The first plate 3201 may connect the first supporting bar 3101 and the second supporting bar 3102. The first plate 3201, the first supporting bar 3101, and the second supporting bar 3102 may be integral. A supporting bar (e.g., the second supporting bar 3102) may connect the first plate 3201 and the second plate 3202. The second supporting bar 3102, the first plate 3201, and the second plate 3202 may be integral. The first supporting bar 3101 may be named as a "first supporting bar portion." The second supporting bar 3102 may be named as a "second supporting bar portion." The first plate 3201 may be named as a "first plate portion." The second plate 3202 may be named as a "second plate portion."

According to an embodiment, the supporting body 300 may include a gap 340 formed between the first supporting bar 3101 and the second supporting bar 3102. The gap 340 may be a space formed between the first supporting bar 3101 and the second supporting bar 3102. The gap 340 may be a space formed between each of the plurality of supporting bars 310. The plate 320 may face the gap 340.

According to an embodiment, the supporting body 300 may include an opening 330 formed between the first plate 3201 and the second plate 3202. The opening 330 may be a space formed between the first plate 3201 and the second plate 3202. The opening 330 may be a space formed between each of the plurality of plates 320. The supporting bar 310 may face the opening 330.

According to an embodiment, a supporting bar 310 may protrude from the plate 320. The supporting bar 310 may include a void 318. The void 318 may be a space formed inside the supporting bar 310. The void 318 may communicate with the opening 330.

According to an embodiment, a supporting bar 310 may include a first portion 311. The first portion 311 may be spaced apart from the plate 320. The first portion 311 may be a portion of the supporting bar 310 extending parallel to the plate 320.

According to an embodiment, a supporting bar 310 may include a first edge 312. The first edge 312 may be a portion of the first portion 311. The first edge 312 may protrude toward an adjacent supporting bar 310. The supporting bar 310 may include a second edge 313. The second edge 313 may be a portion of the first portion 311. The second edge 313 may protrude toward an adjacent supporting bar (e.g., the second supporting bar 3102). The first edge 312 and the second edge 313 may protrude in opposite directions.

According to an embodiment, a supporting bar 310 may include a second portion 314, 315. The second portion 314, 315 may connect the first portion 311 and the plate 320. The second portion 314, 315 may be connected to the edges 312, 313 of the first portion 311. The second portion 314, 315 may include a first side wall 314 and a second side wall 315. The first side wall 314 and the second side wall 315 may be spaced apart from each other. The void 318 may be formed between the first side wall 314 and the second side wall 315. The first side wall 314 may extend obliquely from the first edge 312 toward the plate 320. The second side wall 315 may extend obliquely from the second edge 313 toward the plate 320. The direction in which the first side wall 314 is inclined and the direction in which the second side wall 315 is inclined may be opposite to each other.

According to an embodiment, the second portion 314, 315 may include connecting portions 316, 317. The connecting portions 316, 317 may be portions of the second portion 314, 315. However, the connecting portions 316, 317 may be portions of the second portion 314, 315 or may be portions of the plate 320. The connecting portions 316, 317 may include a first connecting portion 316 and a second connecting portion 317. The first connecting portion 316 may be a portion of the first side wall 314 connected to the plate 320. The second connecting portion 317 may be a portion of the second side wall 315 connected to the plate 320. The first connecting portion 316 and the second connecting portion 317 may be spaced apart from each other. The opening 330 may be formed between the first connecting portion 316 and the second connecting portion 317. The first connecting portion 316 and the second connecting portion 317 may be formed convexly toward the opening 330.

According to an embodiment, the shape of the cross-section of the supporting bar 310 may have a dovetail shape. However, the shape of the supporting bar 310 is not limited thereto. For example, the shape of the cross-section of the supporting bar 310 may be a rectangular shape with one side open.

According to an embodiment, a plate 320 may include a plate body 321 and plate holes 322. The plate body 321 may connect the plurality of supporting bars 310. The plate holes 322 may be opened in the plate body 321. The plurality of plate holes 322 may be formed spaced apart from each other.

According to an embodiment, the thickness of the supporting body 300 may be variable. For example, the thickness of each portion (e.g., the supporting bar 310, the plate 320) constituting the supporting body 300 may be different. The thickness of the supporting bar 310 and the thickness of the plate 320 may be different from each other. The thickness of the supporting bar 310 may be greater than the thickness of the plate 320. For example, a thickness t1 of the first portion 311 may be greater than a thickness t2 of the plate 320. For example, thicknesses t3, t4 of the second portion 314, 315 may be greater than the thickness t2 of the plate 320.

According to an embodiment, the thicknesses t3, t4 of the second portion 314, 315 may be greater than the thickness t1 of the first portion 311. The thicknesses t3, t4 of the second portion 314, 315 may be greater than the thickness t2 of the plate 320. A thickness t3 of the first side wall 314 and a thickness t4 of the second side wall 315 may be substantially the same. The second portion 314, 315 may connect the first portion 311 and the plate 320, and its thickness may be greater than the respective thicknesses t1, t2 of the first portion 311 and the plate 320. The supporting body 300 according to an embodiment of the disclosure may enhance the rigidity of the supporting body 300 by forming the thickness of the second portion 314, 315 greater than the remaining portions (e.g., the first portion 311, the plate 320).

According to an embodiment, the thickness t1 of the first portion 311 may be in a range of 0.05mm to 1.2mm. The thicknesses t3, t4 of the second portion 314, 315 may be in a range of 0.05mm to 2mm. However, within the range (e.g., within 0.05mm to 2mm), the thicknesses t3, t4 of the second portion 314, 315 may be greater than the thickness t1 of the first portion 311. The thickness t2 of the plate 320 may be in a range of 0.05mm to 0.2mm. However, within the range (e.g., within 0.05mm to 0.2mm), the thickness t2 of the plate 320 may be less than the thicknesses t1, t3, t4 of the supporting bar 310. A distance h from the first portion 311 to the plate 320 may be in a range of 0.3mm to 1.2mm.

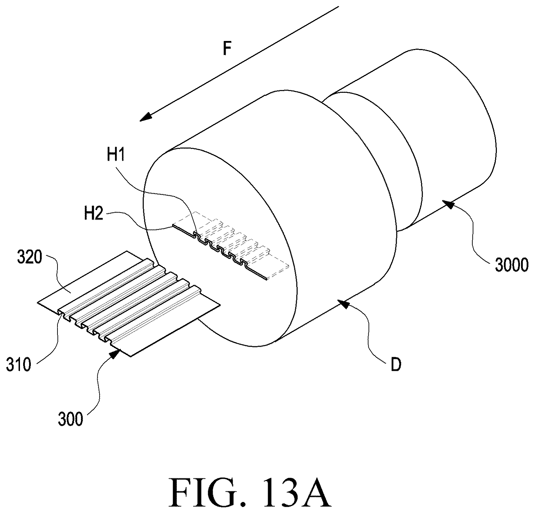

According to an embodiment, the supporting bar 310 and the plate 320 may be formed integrally. The thicknesses of the supporting bar 310 and the plate 320 may be different from each other. The supporting body 300 may be manufactured by a drawing process. The drawing process may be the process illustrated in FIGS. 13A to 13C. For example, referring to FIGS. 13A to 13C, the supporting body 300 may be manufactured by inputting a processing material 3000 into a mold D having a drawing hole H corresponding to the shape of the supporting body 300. The supporting body 300 according to an embodiment of the disclosure may manufacture the supporting bar 310 and the plate 320 having different thicknesses integrally by inputting and processing the processing material 3000 into the mold D in which the size of the hole H1 corresponding to the supporting bar 310 and the size of the hole H2 corresponding to the plate 320 are different.

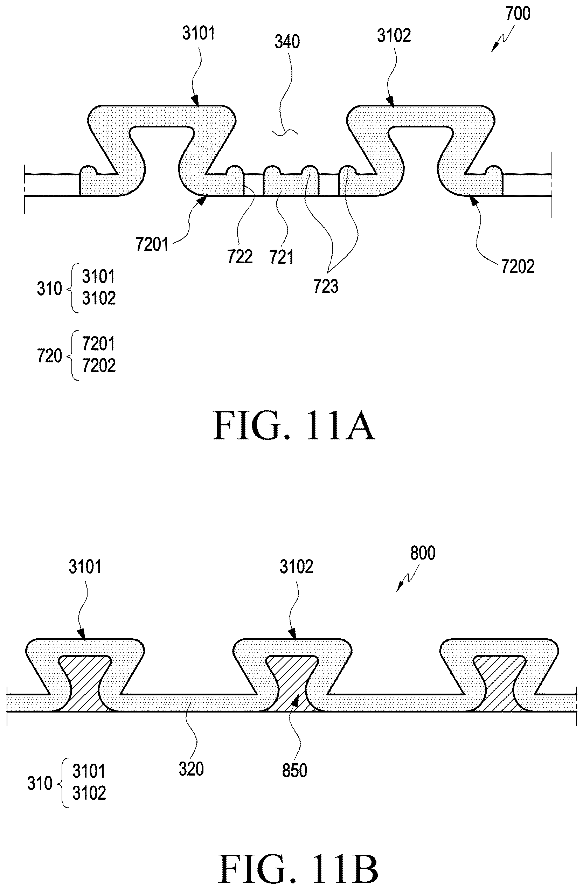

FIGS. 10A, 10B, 10C, 10D, 10E, and 10F are views illustrating the shape of the cross-section of a supporting bar according to each embodiment of the disclosure. Components described with reference to FIGS. 10A to 10F may be identical in whole or part to the components described with reference to FIGS. 1 to 9. Components described with reference to FIGS. 10A to 10F may be identical in whole or part to the components described with reference to FIGS. 11A to 13D.

According to various embodiments of the disclosure, supporting bars (e.g., the supporting bars 410, 510, 610, 6101, 6102, 6103 of FIGS. 10A to 10F) may have various cross-sectional shapes. The cross-sectional shapes of the plurality of supporting bars may all be the same, or the cross-sectional shapes of each of the plurality of supporting bars may be different from each other. For example, the cross-section of any one supporting bar among the plurality of supporting bars may have a shape as illustrated in FIG. 8, the cross-section of another supporting bar among the plurality of supporting bars may have a shape as illustrated in FIG. 10A, and the cross-section of yet another supporting bar among the plurality of supporting bars may have a shape as illustrated in FIG. 10B. However, the shape of the cross-section of the supporting bar is not limited thereto and may be configured by various combinations.

Referring to FIG. 10A, a supporting body 400 may include a supporting bar 410 and a plate 320. The plate 320 may be the same as the plate 320 described with reference to FIGS. 7 to 9. The supporting bar 410 may include a second portion 414, 415. The second portion 414, 415 may connect the first portion 411 and the plate 320. The supporting bar 410 may include a first portion 411. The first portion 411 may include a first edge 412 connected to the first side wall 414 and a second edge 413 connected to the second side wall 415. The supporting bar 410 may include a recess 419. The recess 419 may be formed in the first portion 411. The recess 419 may be formed by being recessed in the surface of the first portion 411. The recess 419 may be formed between the first edge 412 and the second edge 413. The plurality of recesses 419 may be formed spaced apart from each other. The recess 419 may include a first recess 4191 and a second recess 4192 spaced apart from each other.

Referring to FIG. 10B, a supporting body 500 may include a supporting bar 510 and a plate 320. The plate 320 may be the same as the plate 320 described with reference to FIGS. 7 to 9. A supporting bar 510 may include a first portion 511 having a first edge 512 and a second edge 513. The supporting bar 510 may include a second portion 514, 515 connecting the first portion 511 and the plate 320. The second portion 514, 515 may include a first side wall 514 connecting the first edge 512 and the plate 320 and a second side wall 515 connecting the second edge 513 and the plate 320. Thicknesses t31, t32, t41, t42 of the second portion 514, 515 may increase as they approach the first portion 511 from the plate 320. For example, thicknesses t31, t41 of the second portion 514, 515 in an area adjacent to the plate 320 may be smaller than thicknesses t32, t42 of the second portion 514, 515 in an area adjacent to the first portion 511. Thicknesses t31, t32 of the first side wall 514 may increase as they approach the first portion 511. Thicknesses t41, t42 of the second side wall 515 may increase as they approach the first portion 511. A width w of the void 518 may be constant between the plate 320 and the first portion 511.

Referring to FIG. 10C, a supporting body 600 may include a supporting bar 610 and a plate 320. The plate 320 may be the same as the plate 320 described with reference to FIGS. 7 to 9. The supporting bar 610 may include a first portion 611. The supporting bar 610 may include a second portion 614, 615 connecting the first portion 611 and the plate 320. The supporting bar 610 may include protrusions 614a, 615a. The protrusions 614a, 615a may protrude from the second portion 614, 615 toward the void 618. The protrusions 614a, 615a may include a first protrusion 614a protruding from the first side wall 614 toward the void 618 and a second protrusion 615a protruding from the second side wall 615 toward the void 618. The plurality of first protrusions 614a may be formed spaced apart along the extending direction of the first side wall 614. The plurality of second protrusions 615a may be formed spaced apart along the extending direction of the second side wall 615.

Referring to FIG. 10D, a supporting body 601 may include a supporting bar 6101 and a plate 320. The plate 320 may be the same as the plate 320 described with reference to FIGS. 7 to 9. The supporting bar 6101 may include a first portion 6111. The supporting bar 6101 may include a second portion 6141, 6151 connecting the first portion 6111 and the plate 320. The second portion 6141, 6151 may include a first side wall 6141 and a second side wall 6151 spaced apart from each other to form a void 6181 therebetween. The supporting bar 6101 may include a protrusion 6111a. The protrusion 6111a may protrude from the first portion 6111 toward the void 618.

Referring to FIG. 10E, a supporting body 602 may include a supporting bar 6102 and a plate 320. The plate 320 may be the same as the plate 320 described with reference to FIGS. 7 to 9. The supporting bar 6102 may include a first portion 6112. The supporting bar 6102 may include a second portion 6142, 6152 connecting the first portion 6112 and the plate 320. The supporting bar 6102 may include protrusions 6142a, 6152a. The protrusions 6142a, 6152a may protrude from the second portion 6142, 6152 toward the plate 320. The protrusions 6142a, 6152a may include a first protrusion 6142a protruding from the first side wall 6142 toward the plate 320 and a second protrusion 6152a protruding from the second side wall 6152 toward the plate 320. The protrusions 6142a, 6152a may protrude from the second portion 6142, 6152 in a direction opposite to the void 6182.

Referring to FIG. 10F, a supporting body 603 may include a supporting bar 6103 and a plate 320. The plate 320 may be the same as the plate 320 described with reference to FIGS. 7 to 9. The supporting bar 6103 may include a first portion 6113. The supporting bar 6103 may include a second portion 6143, 6153 connecting the first portion 6113 and the plate 320. The second portion 6143, 6153 may include a first side wall 6143 and a second side wall 6153 spaced apart from each other to form a void 6183 therebetween. The supporting bar 6103 may include a recess 6113a. The recess 6113a may be formed by being recessed in the first portion 6113. The recess 6113a may be recessed in a direction from the surface of the first portion 6113 toward the void 6183.

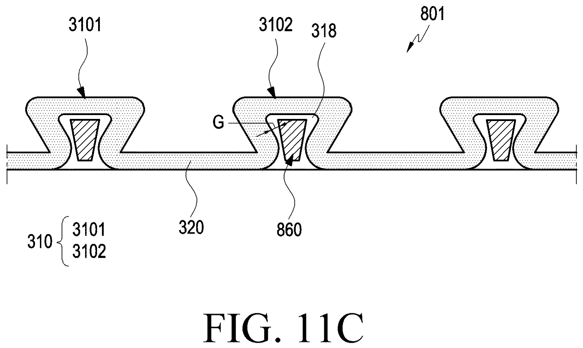

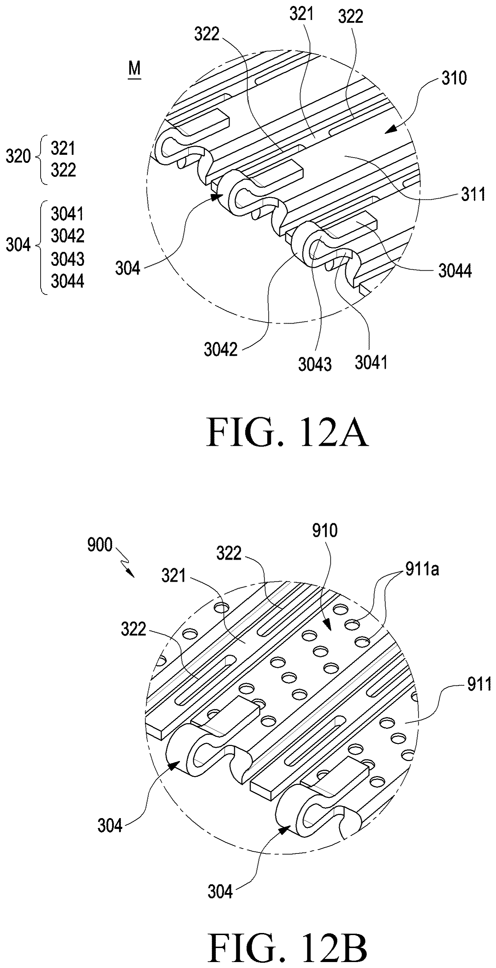

FIGS. 11A, 11B, and 11C are views illustrating cross-sectional shapes of supporting bodies 700, 800, 801 according to various embodiments of the disclosure. Components described with reference to FIGS. 11A to 11C may be identical in whole or part to the components described with reference to FIGS. 1 to 10F. Components described with reference to FIGS. 11A to 11C may be identical in whole or part to the components described with reference to FIGS. 12A to 13D.

Referring to FIG. 11A, a supporting body 700 may include a supporting bar 310 and a plate 720. The supporting bar 310 may be the same as the supporting bar 310 described with reference to FIGS. 7 to 9. For example, the supporting bar 310 may include a first supporting bar 3101 and a second supporting bar 3102 spaced apart from each other, and a gap 340 may be formed between the first supporting bar 3101 and the second supporting bar 3102. A plate 720 may include a first plate 7201 and a second plate 7202 spaced apart from each other. The supporting bar 310 (e.g., the second supporting bar 3102) may connect the first plate 7201 and the second plate 7202. The plate 720 may include a plate body 721 and plate holes 722. The plate body 721 may connect the first supporting bar 3101 and the second supporting bar 3102. The plate holes 722 may be formed by being opened in the plate body 721. The plurality of plate holes 722 may be formed spaced apart from each other between the first supporting bar 3101 and the second supporting bar 3102. The plate 720 may include a body protrusion 723. The body protrusion 723 may protrude from the plate body 721 toward the gap 340 formed between the first supporting bar 3101 and the second supporting bar 3102. The body protrusion 723 may be formed between the plurality of plate holes 722. The plurality of body protrusions 723 may be formed spaced apart in a direction in which the plurality of plate holes 722 are spaced apart from each other.

Referring to FIG. 11B, a supporting body 800 may include a supporting bar 310 and a plate 320. The supporting bar 310 may be the same as the supporting bar 310 described with reference to FIGS. 7 to 9. For example, the supporting bar 310 may include a first supporting bar 3101 and a second supporting bar 3102 spaced apart from each other. The plate 320 may be the same as the plate 320 described with reference to FIGS. 7 to 9. The supporting body 800 may include a damping member 850 disposed in the void 318 of the supporting bar 310. The damping member 850 may be inserted into the void 318 of the supporting bar 310 and fixed to the supporting bar 310. The damping member 850 may be manufactured by molding a molding material (e.g., resin). For example, the damping member 850 may be formed by hardening a molding material (e.g., resin) input into the void 318 of the supporting bar 310.

Referring to FIG. 11C, a supporting body 801 may include a supporting bar 310 and a plate 320. The supporting bar 310 may be the same as the supporting bar 310 described with reference to FIGS. 7 to 9. For example, the supporting bar 310 may include a first supporting bar 3101 and a second supporting bar 3102 spaced apart from each other. The plate 320 may be the same as the plate 320 described with reference to FIGS. 7 to 9. The supporting body 801 may include a heat dissipation member 860 disposed in the void 318 of the supporting bar 310. The heat dissipation member 860 may be a heat dissipation fin or may be a heat transfer tube. The heat dissipation member 860 may be spaced apart from the supporting bar 310. A gap G may be formed between the heat dissipation member 860 and the supporting bar 310.

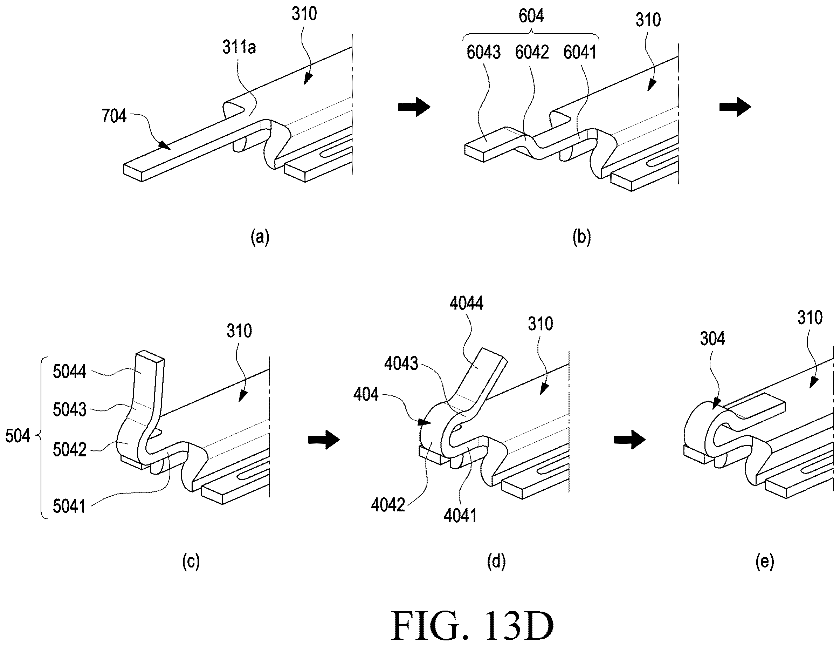

FIGS. 12A and 12B are enlarged views illustrating area M illustrated in FIG. 7 according to different embodiments. Components described with reference to FIGS. 12A and 12B may be identical in whole or part to the components described with reference to FIGS. 1 to 11C. Components described with reference to FIGS. 12A and 12B may be identical in whole or part to the components described with reference to FIG. 13D.

According to an embodiment, a plate 320 may be a lattice plate. The plate 320 may include a plate body 321 and plate holes 322. The plurality of plate holes 322 may be formed. The plurality of plate holes 322 may be spaced apart from each other in the extending direction of the plate body 321. The plate holes 322 may have a slit shape extending along the extending direction of the plate body 321.

According to an embodiment, a head 304 may extend from the supporting bar 310. The head 304 may be formed integrally with the supporting bar 310. The head 304 may extend from the first portion 311.

According to an embodiment, a head 304 may include a first head portion 3041. The first head portion 3041 may be connected to the first portion 311. The head 304 may include a curved portion 3042. The curved portion 3042 may be formed convexly in a direction away from the supporting bar 310. The curved portion 3042 may be inserted into a guide rail (e.g., the guide rail 215 of FIG. 4A). The head 304 may include a bending portion 3043. The bending portion 3043 may extend from the curved portion 3042 toward the supporting bar 310. The head 304 may include a second head portion 3044. The second head portion 3044 may extend from the bending portion 3043 toward the first portion 311. The second head portion 3044 may contact the surface of the first portion 311.

Referring to FIG. 12B, a supporting body 900 may include a head 304, a supporting bar 910, and a plate 320. The head 304 may be the same as the head 304 described with reference to FIG. 12A. The plate 320 may be the same as the plate 320 described with reference to FIGS. 7 to 9. The supporting bar 910 may include a first portion 911. The first portion 911 may be formed integrally with the head 304. The supporting bar 910 may include a recess 911a. The recess 911a may be formed by being recessed in the first portion 911. The plurality of recesses 911a may be formed.

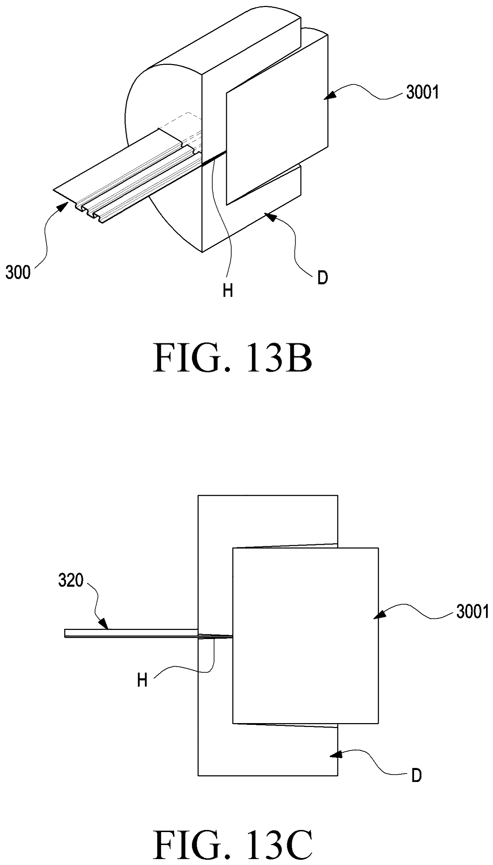

FIG. 13A is a view illustrating a process of manufacturing the supporting body 300 according to an embodiment of the disclosure. FIG. 13B is a cross-sectional perspective view vertically cutting the structures of FIG. 13A in the process of molding the supporting body 300. FIG. 13C is a cross-sectional view illustrating FIG. 13B viewed from one side. FIG. 13D is a view illustrating a process of manufacturing a head 304 according to an embodiment of the disclosure. Components described with reference to FIGS. 13A to 13D may be identical in whole or part to the components described with reference to FIGS. 1 to 12B.

Referring to FIGS. 13A to 13C, the supporting body 300 may be manufactured by passing a processing material 3000 through a mold D having a hole H corresponding to the shape of the supporting body 300. The supporting body 300 may be manufactured by a drawing process. The mold D may include a first hole H1 corresponding to the shape of the supporting bar 310 and a second hole H2 corresponding to the shape of the plate 320. The width of the first hole H1 and the width of the second hole H2 may be different from each other. After passing through the first hole H1, the supporting bar 310 may have a thickness corresponding to the width of the first hole H1. After passing through the second hole H2, the plate 320 may have a thickness corresponding to the width of the second hole H2. The processing material 3000 may be inserted into the mold D in a first direction F and may be molded while moving along the first direction F. A portion of the processing material 3000 may be molded into the shape of the supporting body 300 while passing through the hole H, and the remaining portion 3001 may be positioned in the mold D. The supporting body 300 may be manufactured by cutting a portion of the processing material 3000 having the shape of the supporting bar 310 and the plate 320 after passing through the mold D.

Referring to FIG. 13D, a head 304 may be manufactured through the processes of (a), (b), (c), (d), and (e) illustrated in FIG. 13D in sequence. The head 304 may be formed by hemming processing. The process (a) of FIG. 13D may be named as a first process. The process (b) of FIG. 13D may be named as a second process. The process (c) of FIG. 13D may be named as a third process. The process (d) of FIG. 13D may be named as a fourth process. The process (e) of FIG. 13D may be named as a fifth process.

According to an embodiment, in the first process, a supporting bar 310 may include an extended portion 704. The extended portion 704 may be a flat plate extending from an end portion 311 a of the supporting bar 310. In the second process, at least a portion of the extended portion 604 may be bent. In the second process, the extended portion 604 may include a first extended portion 6041 connected to the supporting bar 310, a stepped portion 6042 connected to the first extended portion 6041, and a second extended portion 6043 connected to the stepped portion 6042. In the third process, at least a portion of the extended portion 504 may be bent. In the third process, the extended portion 504 may include a first extended portion 5041, a curved portion 5042 curved in a direction intersecting the first extended portion 5041, a bent portion 5043 connected to the curved portion 5042, and a second extended portion 5044 extending from the bent portion 5043. In the fourth process, the extended portion 404 may be bent toward the supporting bar 310. In the fourth process, the extended portion 404 may include a first extended portion 4041, a curved portion 4042, a bent portion 4043, and a second extended portion 4044. In the fifth process, the second extended portion 4044 may be coupled to the supporting bar 310, and the head 304 may be formed.

An electronic device includes a housing and a display, and the display may have at least a portion movably disposed together with the housing so that the area displayed externally may be variable. The electronic device may include a supporting body that supports the movement of the display, and the supporting body may be manufactured by assembling a plurality of components. When the supporting body is manufactured by assembling a plurality of components, costs are incurred due to the assembly process, and bonding members used for joining between components may adversely affect the environment.

An object of the disclosure may be to form the supporting body of the display integrally.

An object of the disclosure may be to enhance the rigidity of the supporting body.

Objects of the disclosure are not limited to the above-mentioned problems, and may be variously determined within a range that does not deviate from the spirit and scope of the disclosure.

An electronic device according to various embodiments of the disclosure may simplify the manufacturing process of the supporting body by integrally forming the supporting bar and the plate constituting the supporting body.

An electronic device according to various embodiments of the disclosure may enhance the rigidity of the supporting body by forming the supporting bar and the plate constituting the supporting body with different thicknesses.

The effects obtainable in the disclosure are not limited to the above-mentioned effects, and other effects not mentioned is clearly understood by those skilled in the art to which the disclosure pertains from the description below.

An electronic device (e.g., 101 of FIG. 1) according to an embodiment of the disclosure may include a housing (e.g., 201, 202 of FIGS. 1 to 13D) including a first housing portion (e.g., 201 of FIGS. 1 to 13D) and a second housing portion (e.g., 202 of FIGS. 1 to 13D) configured to move between a retracted position and an extended position relative to the first housing portion (e.g., 201 ofFIGS. 1 to 13D).

The electronic device (e.g., 101 of FIG. 1) according to an embodiment of the disclosure may include a flexible display (e.g., 203 of FIGS. 1 to 13D) movably disposed on the housing (e.g., 201, 202 ofFIGS. 1 to 13D).

The electronic device (e.g., 101 of FIG. 1) according to an embodiment of the disclosure may include a supporting body (e.g., 300; 400; 500; 600; 601; 602; 603; 700; 800; 801; 900 of FIGS. 1 to 13D) configured to support at least a portion of the flexible display (e.g., 203 of FIGS. 1 to 13D).

The supporting body (e.g., 300; 400; 500; 600; 601; 602; 603; 700; 800; 801; 900 of FIGS. 1 to 13D) according to an embodiment of the disclosure may include a plate (e.g., 320; 720 of FIGS. 1 to 13D) including a first plate portion (e.g., 3201 ofFIGS. 1 to 13D) facing the flexible display (e.g., 203 of FIGS. 1 to 13D) and a second plate portion (e.g., 3202 of FIGS. FIGS. 1 to 13D) facing the flexible display (e.g., 203 of FIGS. 1 to 13D) and forming an opening (e.g., 330 of FIGS. 1 to 13D) between the first plate portion (e.g., 3201 ofFIGS. 1 to 13D) and the second plate portion.

The supporting body (e.g., 300; 400; 500; 600; 601; 602; 603; 700; 800; 801; 900 of FIGS. 1 to 13D) according to an embodiment of the disclosure may include a supporting bar (e.g., 310; 410; 510; 610; 6101; 6102; 6103; 910 of FIGS. 1 to 13D) connecting the first plate portion (e.g., 3201 of FIGS. 1 to 13D) and the second plate portion (e.g., 3202 of FIGS. 1 to 13D) and formed integrally with the first plate portion (e.g., 3201 ofFIGS. 1 to 13D) and the second plate portion (e.g., 3202 of FIGS. 1 to 13D).

The supporting bar (e.g., 310; 410; 510; 610; 6101; 6102; 6103; 910 of FIGS. 1 to 13D) according to an embodiment of the disclosure may include a first portion (e.g., 311; 411; 511; 611; 6111; 6112; 6113; 911 ofFIGS. 1 to 13D) spaced apart from the opening (e.g., 330 of FIGS. 1 to 13D).

The supporting bar (e.g., 310; 410; 510; 610; 6101; 6102; 6103; 910 of FIGS. 1 to 13D) according to an embodiment of the disclosure may include a second portion (e.g., 314, 315; 414, 415; 514, 515; 614, 615; 6141, 6151; 6142, 6152; 6143, 6153 of FIGS. 1 to 13D) extending from the plate (e.g., 320; 720 of FIGS. 1 to 13D) with a thickness different from the plate (e.g., 320; 720 of FIGS. 1 to 13D) and connected to the first portion (e.g., 311; 411; 511; 611; 6111; 6112; 6113; 911 ofFIGS. 1 to 13D).

The thicknesses (t3, t4) of the second portion (e.g., 314, 315 of FIGS. 1 to 13D) according to an embodiment of the disclosure may be greater than the thickness (t2) of the plate (e.g., 320 of FIGS. 1 to 13D).

The thicknesses (t3, t4) of the second portion (e.g., 314, 315 ofFIGS. 1 to 13D) according to an embodiment of the disclosure may be greater than the thickness (t1) of the first portion (e.g., 311 of FIGS. 1 to 13D).

The thickness (t1) of the first portion (e.g., 311 of FIGS. 1 to 13D) according to an embodiment of the disclosure may be greater than the thickness (t2) of the plate (e.g., 320 of FIGS. 1 to 13D).

The second portion (e.g., 314, 315 of FIGS. 1 to 13D) according to an embodiment of the disclosure may include a first side wall (e.g., 314 of FIGS. 1 to 13D) connecting the first plate portion (e.g., 3201 ofFIGS. 1 to 13D) and the first portion (e.g., 311 ofFIGS. 1 to 13D).

The second portion (e.g., 314, 315 of FIGS. 1 to 13D) according to an embodiment of the disclosure may include a second side wall (e.g., 315 of FIGS. 1 to 13D) connecting the second plate portion (e.g., 3202 of FIGS. 1 to 13D) and the first portion (e.g., 311 of FIGS. 1 to 13D).

The first portion (e.g., 311 ofFIGS. 1 to 13D) according to an embodiment of the disclosure may include a first edge (e.g., 312 of FIGS. 1 to 13D) connected to the first side wall (e.g., 314 of FIGS. 1 to 13D).

The first portion (e.g., 311 ofFIGS. 1 to 13D) according to an embodiment of the disclosure may include a second edge (e.g., 313 of FIGS. 1 to 13D) connected to the second side wall (e.g., 315 of FIGS. 1 to 13D).

The second portion (e.g., 314, 315 of FIGS. 1 to 13D) according to an embodiment of the disclosure may include a first connecting portion (e.g., 316 of FIGS. 1 to 13D) connecting the first side wall (e.g., 314 of FIGS. 1 to 13D) and the first plate portion (e.g., 3201 of FIGS. 1 to 13D) and formed convexly toward the opening (e.g., 330 of FIGS. 1 to 13D).

The second portion (e.g., 314, 315 of FIGS. 1 to 13D) according to an embodiment of the disclosure may include a second connecting portion (e.g., 317 of FIGS. 1 to 13D) connecting the second side wall (e.g., 315 of FIGS. 1 to 13D) and the second plate portion (e.g., 3202 of FIGS. 1 to 13D) and formed convexly toward the opening (e.g., 330 of FIGS. 1 to 13D).

The supporting bar (e.g., 310 ofFIGS. 1 to 13D) according to an embodiment of the disclosure may include a void (e.g., 318 of FIGS. 1 to 13D) communicating with the opening (e.g., 330 ofFIGS. 1 to 13D).

The supporting bar (e.g., 410 of FIGS. 1 to 13D) according to an embodiment of the disclosure may include a recess (e.g., 419 of FIGS. 1 to 13D) recessed in the first portion (e.g., 411 of FIGS. 1 to 13D).

The thickness of the second portion (e.g., 514, 515 of FIGS. 1 to 13D) according to an embodiment of the disclosure may increase toward the first portion (e.g., 511 of FIGS. 1 to 13D) from the plate (e.g., 320 of FIGS. 1 to 13D).

The supporting bar (e.g., 610; 6101 of FIGS. 1 to 13D) according to an embodiment of the disclosure may include a void (e.g., 618; 6181 of FIGS. 1 to 13D) communicating with the opening (e.g., 330 of FIGS. 1 to 13D).

The supporting bar (e.g., 610; 6101 of FIGS. 1 to 13D) according to an embodiment of the disclosure may include a protrusion (e.g., 614a, 615a; 6111a of FIGS. 1 to 13D) protruding toward the void (e.g., 618; 6181 ofFIGS. 1 to 13D).

The supporting bar (e.g., 310 of FIGS. 1 to 13D) according to an embodiment of the disclosure may include a first supporting bar (e.g., 3101 of FIGS. 1 to 13D) connecting the first plate portion (e.g., 7201 of FIGS. 1 to 13D) and the second plate portion (e.g., 7202 of FIGS. 1 to 13D).

The supporting bar (e.g., 310 ofFIGS. 1 to 13D) according to an embodiment of the disclosure may include a second supporting bar (e.g., 3102 of FIGS. 1 to 13D) spaced apart from the first supporting bar (e.g., 3101 of FIGS. 1 to 13D) and forming a gap (e.g., 340 of FIGS. 1 to 13D) between the first supporting bar (e.g., 3101 of FIGS. 1 to 13D) and the second supporting bar.

The plate (e.g., 720 of FIGS. 1 to 13D) according to an embodiment of the disclosure may include a body protrusion (e.g., 723 of FIGS. 1 to 13D) protruding toward the gap (e.g., 340 of FIGS. 1 to 13D) between the first supporting bar (e.g., 3101 of FIGS. 1 to 13D) and the second supporting bar (e.g., 3102 ofFIGS. 1 to 13D).

The supporting body (e.g., 800 ofFIGS. 1 to 13D) according to an embodiment of the disclosure may include a damping member (e.g., 850 of FIGS. 1 to 13D) disposed between the first side wall (e.g., 314 of FIGS. 1 to 13D) and the second side wall (e.g., 315 of FIGS. 1 to 13D).

The supporting body (e.g., 801 of FIGS. 1 to 13D) according to an embodiment of the disclosure may include a heat dissipation member (e.g., 860 of FIGS. 1 to 13D) disposed between the first side wall (e.g., 314 of FIGS. 1 to 13D) and the second side wall (e.g., 315 of FIGS. 1 to 13D).

The supporting bar (e.g., 910 of FIGS. 1 to 13D) according to an embodiment of the disclosure may include a recess (e.g., 911a of FIGS. 1 to 13D) recessed in the first portion (e.g., 911 ofFIGS. 1 to 13D).

The supporting body (e.g., 300; 400; 500; 600; 601; 602; 603; 700; 800; 801; 900 of FIGS. 1 to 13D) according to an embodiment of the disclosure may include a plate (e.g., 320 of FIGS. 1 to 13D) including a first plate portion (e.g., 3201 of FIGS. 1 to 13D) facing the flexible display (e.g., 203 of FIGS. 1 to 13D) and a second plate portion (e.g., 3202 of FIGS. 1 to 13D) facing the flexible display (e.g., 203 of FIGS. 1 to 13D) and forming an opening (e.g., 330 of FIGS. 1 to 13D) between the first plate portion (e.g., 3201 of FIGS. 1 to 13D) and the first plate portion.

The supporting body (e.g., 300; 400; 500; 600; 601; 602; 603; 700; 800; 801; 900 of FIGS. 1 to 13D) according to an embodiment of the disclosure may include a supporting bar (e.g., 310; 410; 510; 610; 6101; 6102; 6103; 910 ofFIGS. 1 to 13D) connecting the first plate portion (e.g., 3201 of FIGS. 1 to 13D) and the second plate portion (e.g., 3202 of FIGS. 1 to 13D) and having a void (e.g., 318 of FIGS.1 to 13D) formed therein communicating with the opening (e.g., 330 of FIGS. 1 to 13D).

The supporting bar (e.g., 310 of FIGS. 1 to 13D) according to an embodiment of the disclosure may be formed integrally with the plate (e.g., 320 of FIGS. 1 to 13D).

The supporting bar (e.g., 310 ofFIGS. 1 to 13D) according to an embodiment of the disclosure may include a first portion (e.g., 311 ofFIGS. 1 to 13D) spaced apart from the opening (e.g., 330 of FIGS. 1 to 13D).

The supporting bar (e.g., 310 of FIGS. 1 to 13D) according to an embodiment of the disclosure may include a second portion (e.g., 314, 315 of FIGS. 1 to 13D) extending from the plate (e.g., 320 of FIGS. 1 to 13D) with a thickness different from the plate (e.g., 320 of FIGS. 1 to 13D) and connected to the first portion (e.g., 311 of FIGS. 1 to 13D).

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a housing (201, 202) including a first housing portion (201) and a second housing portion (202) configured to move with respect to the first housing portion (201) between a retracted position and an extended position;
a flexible display (203) movably disposed on the housing (201, 202); and
a supporting body (300; 400; 500; 600; 601; 602; 603; 700; 800; 801; 900) configured to support at least a portion of the flexible display (203), and wherein the supporting body (300; 400; 500; 600; 601; 602; 603; 700; 800; 801; 900) comprises:
a plate (320; 720) including a first plate portion (3201) facing the flexible display (203) and a second plate portion (3202) facing the flexible display (203), wherein an opening (330) is formed between the first plate portion (3201) and the second plate portion (3202); and
a supporting bar (310; 410; 510; 610; 6101; 6102; 6103; 910) connecting the first plate portion (3201) and the second plate portion (3202) and formed integrally with the first plate portion (3201) and the second plate portion (3202), and wherein the supporting bar (310; 410; 510; 610; 6101; 6102; 6103; 910) comprises:
a first portion (311; 411; 511; 611; 6111; 6112; 6113; 911) spaced apart from the opening (330); and
a second portion (314, 315; 414, 415; 514, 515; 614, 615; 6141, 6151; 6142, 6152; 6143, 6153;) extending from the plate (320; 720), having a thickness different from a thickness of the plate (320; 720) and connected to the first portion (311; 411; 511; 611; 6111; 6112; 6113; 911).

2. The electronic device of claim 1, wherein a thickness (t3, t4) of the second portion (314, 315) is greater than a thickness (t2) of the plate (320).

3. The electronic device of claim 1 or 2, wherein a thickness (t3, t4) of the second portion (314, 315) is greater than a thickness (t1) of the first portion (311).

4. The electronic device of any one of claims 1 to 3, wherein a thickness (t1) of the first portion (311) is greater than a thickness (t2) of the plate (320).

5. The electronic device of any one of claims 1 to 4, wherein the second portion (314, 315) comprises:
a first side wall (314) connecting the first plate portion (3201) and the first portion (311); and
a second side wall (315) connecting the second plate portion (3202) and the first portion (311).

6. The electronic device of claim 5, wherein the first portion (311) comprises:
a first edge (312) connected to the first side wall (314); and
a second edge (313) connected to the second side wall (315).

7. The electronic device of claim 5 or 6, wherein the second portion (314, 315) comprises:
a first connecting portion (316) connecting the first side wall (314) and the first plate portion (3201) and formed convexly toward the opening (330); and
a second connecting portion (317) connecting the second side wall (315) and the second plate portion (3202) and formed convexly toward the opening (330).

8. The electronic device of any one of claims 1 to 7, wherein the supporting bar (310) comprises a void (318) in communication with the opening (330).

9. The electronic device of any one of claims 1 to 8, wherein the supporting bar (410) comprises a recess (419) recessed in the first portion (411).

10. The electronic device of any one of claims 1 to 9, wherein a thickness of the second portion (514, 515) increases toward the first portion (511) from the plate (320).

11. The electronic device of any one of claims 1 to 10, wherein the supporting bar (610; 6101) comprises:
a void (618; 6181) in communication with the opening (330); and
a protrusion (614a, 615a; 6111a) protruding toward the void (618; 6181).

12. The electronic device of any one of claims 1 to 11, wherein the supporting bar (310) comprises:
a first supporting bar (3101) connecting the first plate portion (7201) and the second plate portion (7202); and
a second supporting bar (3102) spaced apart from the first supporting bar (3101), wherein a gap (340) is formed between the first supporting bar (3101) and the second supporting bar (3102), wherein the plate (720) comprises a body protrusion (723) protruding toward the gap (340) formed between the first supporting bar (3101) and the second supporting bar (3102).

13. The electronic device of any one of claims 1 to 12, wherein the second portion (314, 315) comprises:
a first side wall (314) connecting the first plate portion (3201) and the first portion (311); and
a second side wall (315) connecting the second plate portion (3202) and the first portion (311), and wherein the supporting body (800) further comprises:
a damping member (850) disposed between the first side wall (314) and the second side wall (315).

14. The electronic device of any one of claims 1 to 13, wherein the second portion (314, 315) comprises:
a first side wall (314) connecting the first plate portion (3201) and the first portion (311); and
a second side wall (315) connecting the second plate portion (3202) and the first portion (311), and wherein the supporting body (801) further comprises:
a heat dissipation member (860) disposed between the first side wall (314) and the second side wall (315).

15. The electronic device of any one of claims 1 to 14, wherein the supporting bar (910) comprises a recess (911a) recessed in the first portion (911).
